# EUROPEAN PATENT APPLICATION

(11) **EP 3 142 253 A1**
(43) Date of publication of application: **15.03.2017**
(21) Application number: 15184888.4
(22) Date of filing: 11.09.2015
(51) Int. Cl.: H03F 3/24, H03F 3/193, H03F 3/45

(54) **RADIO FREQUENCY CIRCUIT**

(71) Applicant: Catena Holding bv, 2628 XG Delft (NL)
(72) Inventor: Esmaeilzadeh Najari, Omid, 164 46 Kista (SE); Carlsson, Mats Lennart, 164 46 Kista (SE)
(74) Representative: Schouten, Marcus Maria

(57) **Abstract**

A radio frequency circuit and a method of supplying power to a circuit block are described. The circuit (200) comprises a circuit block (202) comprising a transformer (230); and at least two inductors (250, 252) for supplying current from a power supply to the circuit block.

## Description

### Field

The disclosure relates to a radio frequency circuit and more particularly to a radio frequency circuit comprising a circuit block and at least two inductors.

### Background

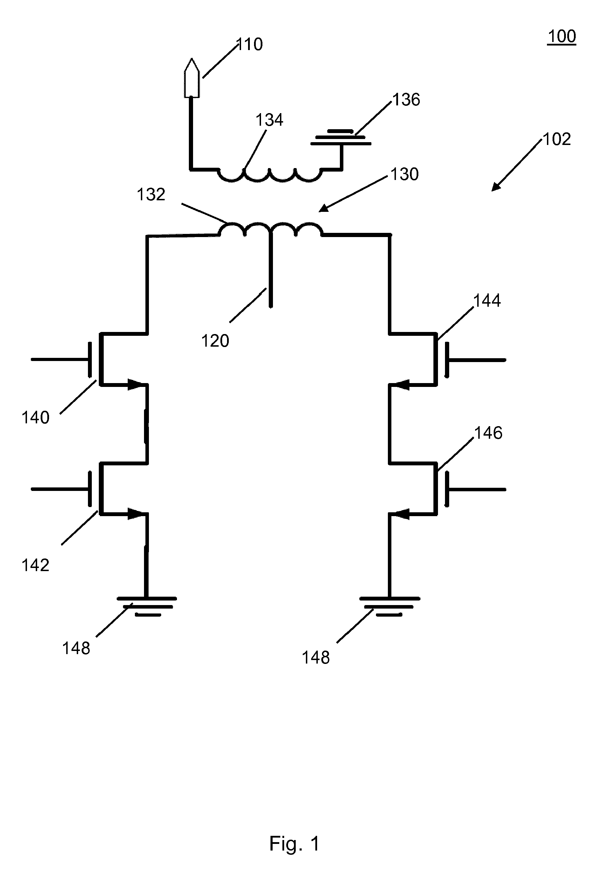

Power amplifiers, such as radio frequency (RF) power amplifiers are used to convert a low power RF signal into a larger signal. Such amplifiers are typically used to drive the antenna of transmitters. DC current for power amplifiers or other circuit blocks employing a transformer/inductor(s) is often provided from the center tap of a transformer/inductor as shown in Figure 1.

In Figure 1, a radio frequency circuit 100 broadly comprises a power amplifier 102, having an output 110 and being fed by a DC current source connection 120. The amplifier comprises a transformer (or inductor pair) 130 having a source or primary side 132 and a secondary side 134. The secondary side is coupled between the output 110 and a ground 136.

The primary side 132 is fed by the DC current source connection 120 at a center tap point 122. The primary side is connected across a series of MOSFETs 140, 142, 144, 146, such as n-type MOSFETs, that connect the transformer 130 to ground 148.

This prior art circuit 100 needs the windings of the transformer/inductor 130 to be wide enough to handle the high DC current required for circuit blocks such as power amplifiers. The wide windings of the transformer 130 result in a larger capacitance between the secondary and primary windings of the transformer and also increase the parasitic capacitance from the transformer/inductor to ground. This lowers the self-resonance frequency (SRF) of the transformer/inductor 130, which also limits the working frequency range of the transformer/inductor 130. The lower SRF at higher frequencies makes impedance matching, provided by the transformer, frequency dependent. This in turn results in memory effects and makes the transformer/inductor not suitable to be used for wideband high data rate applications. Wider transformer/inductor turns also increase the eddy current loss and lowers the quality factor of the transformer/inductor.

### Summary

According to a first aspect of the present disclosure, there is provided a radio frequency circuit comprising: a circuit block comprising a transformer; and at least two inductors for supplying current from a power supply to the circuit block.

By supplying current in this manner, the transformer of the circuit block may be designed with thinner windings and hence an increasing quality factor and self-resonance frequency (SFR).

Furthermore, this circuit may decrease the frequency dependency of the impedance matching provided by the transformer, or more specifically a balun, and as result makes it suitable for wideband applications.

In embodiments, the at least two inductors are connected between the power supply and opposing ends of the circuit block.

A capacitor may be provided for tuning out the inductance of the circuit at a desired frequency. In this way, the overall inductance seen at the output of the circuit can be tuned out by the capacitor for a designed frequency.

At least one of the at least two inductors may be a bond wire. It can be appreciated that bond wire inductance therefore provides the inductance required.

The power supply may be a DC power supply for supplying DC current.

The inductors may be connected across the circuit block. Typically, as shown in figure 1, power is supplied directly to a transformer via a tap.

The circuit block may be a power amplifier. The circuit block may be an RF power amplifier.

According to a second aspect of the present disclosure, there is provided a radio frequency device comprising the radio frequency circuit of any feature of the first aspect.

According to a third aspect of the present invention, there is provided a method of supplying current to a circuit block, said method comprising the steps of: providing a circuit block with a transformer; connecting the circuit block to a power supply using at least two inductors arranged across the circuit block; and supplying current from the power supply to the circuit block.

In embodiments, the method may further comprise the steps of: selecting a capacitor having a value to tune out the inductance of the circuit block at a designed frequency; and providing the capacitor across the output of the circuit block.

At least one of the at least two inductors may be bond wires. Additionally or alternatively, the circuit block may be a power amplifier.

In addition to above mentioned benefits, the aspects also reduce the size of any integrated transformer and its associated cost.

These and other aspects of the invention will be apparent from, and elucidated with reference to, the embodiments described hereinafter.

### Brief description of Drawings

Embodiments will be described, by way of example only, with reference to the drawings, in which
figure 1 illustrates a prior art radio frequency circuit;
figure 2 illustrates a radio frequency circuit according to an embodiment of the present disclosure; and
figure 3 illustrates an alternative radio frequency circuit according to an alternative embodiment of the present disclosure.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar feature in modified and different embodiments.

### Detailed description of embodiments

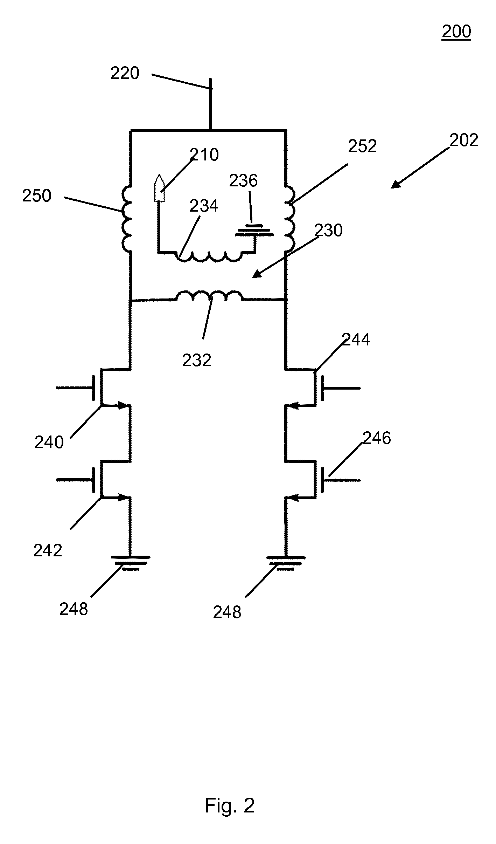

Figure 2 shows a radio frequency circuit 200 comprising a power amplifier 202 having an output 210 and being fed by a DC current source connection 220. The amplifier 202 comprises a transformer (or inductor pair) 230 having a source or primary side 232 and a secondary side 234. The secondary side 234 is coupled between the output 210 and a ground 236.

The primary side 232 is connected across its output by a series of MOSFETs 240, 242, 244, 246, such as n-type MOSFETs, that act to control the output of the amplifier 202 and connect the transformer 230 to ground 248.

DC current is fed to the primary side 232 of the amplifier 202 from a DC current source connection 220 via two inductors 250, 252. The two inductors 250, 252 are connected between the DC current source connection 220 and opposing ends of the primary side 232 of the transformer 230 to supply DC current to the amplifier 202. The inductors 250, 252 may be bond-wire inductors. It can be appreciated that more inductors can be provided in series or in parallel to each other.

Compared to the circuit 100 of figure 1, the transformer 230 of the circuit 200 in figure 2 uses thinner windings, and has a high quality factor a high self-resonance frequency. The circuit 200 also has a low frequency dependence of impedance matching of the transformer 230, making it suited for wideband applications.

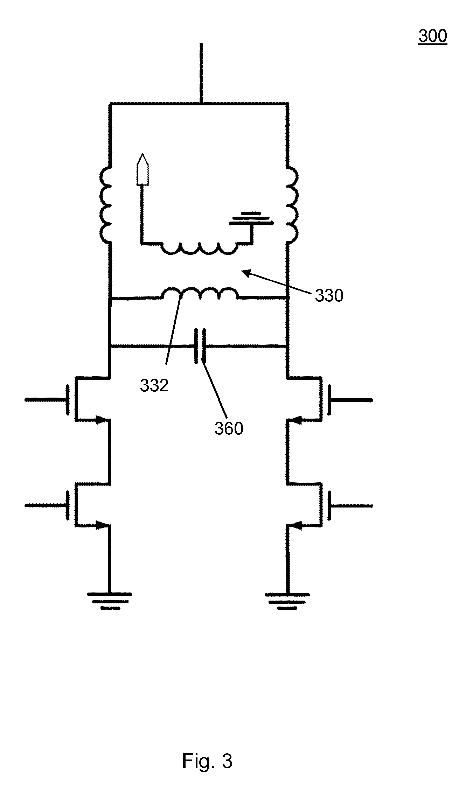

An alternative embodiment of the radio frequency circuit 200 of figure 2 is shown in figure 3. Figure 3 shows a radio frequency circuit 300 that is identical to that in figure 2, albeit with the addition of a capacitor 360 connected between opposing ends of the primary side 332 of the transformer 330. The capacitor is configured to tune out the overall inductance of the circuit 300 at the desired frequency of the circuit 300.

From reading the present disclosure, other variations and modifications will be apparent to the skilled person. Such variations and modifications may involve equivalent and other features which are already known in the art of amplifiers, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality and reference signs in the claims shall not be construed as limiting the scope of the claims.

## Claims

1. A radio frequency circuit comprising:
a circuit block comprising a transformer; and
at least two inductors for supplying current from a power supply to the circuit block.

2. A circuit as claimed in claim 1, wherein the at least two inductors are connected between the power supply and opposing ends of the circuit block.

3. A circuit as claimed in claim 1 or 2, further comprising a capacitor for tuning out the inductance of the circuit at a desired frequency.

4. A circuit as claimed in any preceding claim, wherein at least one of the at least two inductors is a bond wire.

5. A circuit as claimed in any preceding claim, wherein the power supply is a DC power supply for supplying DC current.

6. A circuit as claimed in any preceding claim, wherein the inductors are connected across the circuit block.

7. A circuit as claimed in any preceding claim, wherein the circuit block is a power amplifier.

8. A radio frequency device comprising the radio frequency circuit of any preceding claim.

9. A method of supplying current to a circuit block, said method comprising the steps of:
providing a circuit block with a transformer;
connecting the circuit block to a power supply using at least two inductors arranged across the circuit block; and
supplying current from the power supply to the circuit block.

10. A method according to any preceding claim, further comprising the steps of:
selecting a capacitor having a value to tune out the inductance of the circuit block at a designed frequency; and
providing the capacitor across the output of the circuit block.

11. A method according to any preceding claim, wherein at least one of the at least two inductors are bond wires.

12. A method according to any preceding claim, wherein the circuit block is a power amplifier.
